# EUROPÄISCHE PATENTSCHRIFT

(11) **EP 1 627 414 B1**
(45) Veröffentlichungstag und Bekanntmachung des Hinweises auf die Patenterteilung: **29.12.2010**
(21) Anmeldenummer: 04709126.9
(22) Anmeldetag: 07.02.2004
(51) Int. Cl.: H01J 37/34

(54) **MAGNETRON-SPUTTER-KATHODE MIT KÜHLPLATTE**
MAGNETRON SPUTTER CATHODE COMPRISING A COOLING PLATE
CATHODE DE PULVERISATION MAGNETRON A PLAQUE DE REFROIDISSEMENT

(30) Priorität: 23.05.2003 DE 10323258
(43) Veröffentlichungstag der Anmeldung: 22.02.2006
(73) Patentinhaber: Applied Materials GmbH & Co. KG, 63755 Alzenau (DE)
(72) Erfinder: KREMPEL-HESSE, Jörg, 63683 Eckartsborn (DE); JISCHKE, Andreas, 63796 Kahl (DE); SCHÜSSLER, Uwe, 63743 Aschaffenburg (DE); WOLF, Hans, 63526 Erleusee (DE)
(74) Vertreter: Schickedanz, Willi
(86) Internationale Anmeldenummer: PCT/DE2004/000208
(87) Internationale Veröffentlichungsnummer: WO 2004/112079

(56) Entgegenhaltungen:
- WO-A-99/31290
- DE-A- 19 746 988
- DE-A- 19 947 935
- DE-C- 4 127 261
- DE-C- 4 127 262
- US-B1- 6 494 999

## Beschreibung

Die Erfindung bezieht sich auf eine Magnetron-Sputter-Kathode mit einem Verschlusselement, das in eine Öffnung der Gehäusewand einer Vakuumkammer einsetzbar ist, wodurch die Öffnung luftdicht verschlossen und das Verschlusselement elektrisch von der Gehäusewand isoliert ist, mit einem Sputter-Target an der Vakuumseite des Verschlusselementes, mit einer Magnetanordnung an dessen Atmosphärenseite und mit einer mit einer Kühlflüssigkeit betriebenen Kühlplatte für das Sputter-Target und mit den weiteren Merkmalen des Anspruchs 1.

Eine Kathode mit den oben explizit genannten Merkmalen ist unter anderem in der US PS 5,458,759 beschrieben.

Bei der dort beschriebenen Ausführung besteht das Verschlusselement aus der Rückenplatte (backing plate) des Sputter-Targets, die mit einem Rahmen versehen wird, der es ermöglicht, die Rückenplatte luftdicht in eine Öffnung der Gehäusewand der Vakuumkammer einzusetzen, so dass sich das mit der Rückenplatte verbundene Sputter-Target in der Vakuumkammer befindet. An der Atmosphäre-Seite der Rückenplatte befindet sich eine Kühlplatte mit offenen Kanälen, die von der Rückenplatte verschlossen werden. Dahinter befindet sich eine bewegbare Magnetanordnung, deren Magnetfeld vor das Sputter-Target reicht.

Aus der Kathode austretende Elektronen werden durch eine an die Kathode angelegte Hochspannung beschleunigt und ionisieren die Gasmoleküle eines Arbeitsgases in der Vakuumkammer. Die dabei entstehenden positiv geladenen Ionen treffen auf das Sputter-Target und schlagen dort Moleküle und Atome heraus, die in dünnen Schichten auf einem Substrat abgeschieden werden. Durch das Magnetfeld werden die Elektronen vor dem Sputter-Target gebündelt, so dass die Ionenausbeute erhöht wird. Entsprechend der Magnetfeldgeometrie bilden sich sogenannte Race-tracks im Sputter-Target aus. Um einen gleichmäßigen Abtrag des Materials zu gewährleisten, lässt sich die Magnetanordnung verschieben.

Die in der US PS 5,458,759 beschriebene Anordnung ist nur für kleine, eine geringe Standzeit aufweisende Sputter-Targets geeignet. Um die Standzeit zu vergrößern, könnte daran gedacht werden, das Sputter-Target zu verbreitern oder mehrere nebeneinander auf dem Verschlusselement anzuordnen. Dabei ist aber Folgendes zu bedenken: Die als Verschlusselement dienende Rückenplatte ist dem Differenzdruck zwischen Vakuum und Atmosphäre ausgesetzt und würde sich daher bei einer zu großen seitlichen Erstreckung durchbiegen. Dies wiederum hätte zur Folge, dass das aus einem spröden Material bestehende Sputter-Target von der Rückenplatte abplatzt bzw. Risse bildet. Auch könnten die das Kühlwasser führenden Kanäle der Kühlplatte nicht mehr dicht genug durch die Rückenplatte verschlossen werden. Die Haltbarkeit einer solchen vergrößert ausgeführten Kathode ist daher nicht sehr groß. Zwar könnte man daran denken, die Rückenplatte dicker und damit stabiler auszuführen, dies hätte aber zur Folge, dass die Kühlwirkung für das Sputter-Target reduziert werden würde. Auch entstünde das Problem, dass das Magnetfeld vor dem Target wegen des größeren Abstandes zu der Magnetanordnung kleiner und somit die Ionenausbeute geringer würde.

Somit besteht das Problem, eine Magnetron-Sputter-Kathode zu schaffen, die eine gegenüber den bisher bekannten Lösungen deutlich vergrößerte Standzeit hat.

US 6,494,999 B1 offenbart eine Magnetron-Sputter-Kathode mit den Merkmalen des Oberbegriffs von Anspruch 1. Dort ist die Kühlplatte an der Vakuumseite zwischen dem als einen Träger ausgeführten Verschlusselement und dem Sputter-Target angeordnet.

Diese Ausgestaltung hat den Vorteil, dass sich die Kühlplatte innerhalb des Vakuums befindet und damit dem Target näher ist, wodurch die Kühlleistung verbessert wird. Der Träger selbst ist ein gesondertes Bauteil, das so ausgestaltet werden kann, dass es die wirkenden Drücke aufnehmen und abstützen kann, ohne dass es zu erheblichen Durchbiegungen kommt. Da sich die Kühlung bei dieser Ausführung innerhalb der Vakuumkammer befindet, benötigt der Träger Durchführungen für die Kühlflüssigkeit.

Eine derartige Anordnung erlaubt eine wesentlich breitere Ausführung der Kathode, da der Träger nicht mehr von der Rückenplatte gebildet ist, sondern ein eigenes Bauteil bildet, das entsprechend den auftretenden Druckbelastungen ausgelegt werden kann.

Der Träger gemäß der US 6,494,999 B1 weist Durchleitungen für die Kühlflüssigkeit auf.

Da die Kühlplatte somit nicht von einem Differenzdruck belastet ist, kann die Kühlplatte mit Kühlkanälen versehen sein und gleichzeitig die Rückenplatte des Sputter-Targets bilden. Dabei haben die Kühlkanäle innerhalb der Kühlplatte einen geschlossenen Querschnitt, so dass die eine Seite der Rückenplatte eine durchgehende Kontaktfläche zum Sputter-Target ausbildet. Dies vereinfacht die Herstellung der Verbindung (bond) zwischen dem Sputter-Target und der als Kühlplatte ausgeführten Rückenplatte.

Damit die Ansprüche an die Formbeständigkeit des Trägers bei einer Druckbelastung nicht zu hoch werden, sind in der US 6, 454, 999 B1 zwischen der Rückenplatte und dem Träger Abstandshalter vorgesehen, so dass zwischen dem zentralen Bereich der Rückenplatte und dem Träger ein Spalt verbleibt. Diese Abstands halter sind über die Fläche der Rückenplatte verteilt.

Das der Erfindung zu Grunde liegende Problem besteht darin, eine Übertragung einer Durchbiegung des Trägers auf das Sputter-Target zu vermeiden.

Erfindungsgemäß werden die Abstandshalter von Stegen (13) gebildet, an denen der Rand der Rückenplatte (3) mit ihrer von dem Sputter-Target abgewandten Seite derart anliegend befestigt ist, dass der Spalt eine Durchbiegung des Trägers erlaubt, weil die Rückenplatte und damit das Sputter-Target druckfrei sind.

Wenn bei der Befestigung der Rückenplatte an der Trägerplatte ein laterales Spiel an den Stegen vorgegeben ist, besteht für die Rückenplatte kein Zwang, einer Durchbiegung des Trägers zu folgen. Die Rückenplatte bleibt gerade und es besteht nicht die Gefahr, dass sich das Sputter-Target von der Rückenplatte löst.

Im einfachsten Fall sind die Stege einstückig mit dem Träger ausgebildet, wobei die Durchleitung der Kühlflüssigkeit durch die Stege erfolgt.

Dies ermöglicht es unter anderem auch, die Zuleitung zu den Kanälen in der Rückenplatte über die Befestigung der Rückenplatte an den Stegen erfolgen zu lassen.

Damit der Träger selbst nicht zu dick wird, wodurch die Magnete zu sehr von dem Sputter-Target entfernt angeordnet sein müssten, wird weiterhin vorgeschlagen, dass der Träger an der Atmosphärenseite wenigstens an seinen Längsseiten zwei randständige Versteifungsrippen aufweist. Diese können gleichzeitig dazu dienen, den Träger in die Öffnung einzupassen. Selbstverständlich kann auch eine umlaufende Versteifungsrippe vorgesehen werden, so dass der Träger eine wannenförmige Gestalt annimmt.

Bei einer verbreiterten Kathoden-Ausführung kann außerdem vorgesehen werden, dass nicht ein einheitliches Sputter-Target vorgesehen wird, sondern nebeneinander wenigstens zwei längliche Sputter-Targets mit je einer Rückenplatte auf dem Träger anzuordnen, wobei jedem Sputter-Target eine Race-Track erzeugende Magnetanordnung zugeordnet ist.

Die Anordnung von mehreren Sputter-Targets hat auch den Vorteil, dass die einzelnen Sputter-Targets ein nicht zu übermäßig großes Gewicht erhalten und damit handhabbar bleiben.

Aber auch einzelne längliche Sputter-Targets könnten sehr schwer werden. Deshalb wird vorgeschlagen, dass jedes Sputter-Target aus mehreren aneinander stoßenden Sputter-Target-Segmenten zusammengesetzt ist. Weiterhin ist jedem Sputter-Target-Segment eine eigene Rückenplatte zugeordnet, die zu diesem Zweck ebenfalls segmentiert ist. Jedes einzelne Segment weist einen eigenen Kühlwasserkreislauf mit einer eigenen Kühlwasserversorgung auf. Prinzipiell kann eine Segmentierung auch dann vorgenommen werden, wenn die Rückenplatte das Verschlusselement selbst ist.

Eine solche Anordnung hat auch den Vorteil, dass die Kühlkreisläufe nicht zu lang werden, so dass auch am Ende des Kreislaufes das Kühlwasser noch ausreichend kühl ist und eine ausreichende Kühlkapazität besitzt, so dass das Target insgesamt eine gleichmäßige Temperatur aufweist.

Um die Erfindung zu verdeutlichen, wird im Folgenden anhand eines Ausführungsbeispiels diese näher dargestellt. Dazu zeigen:

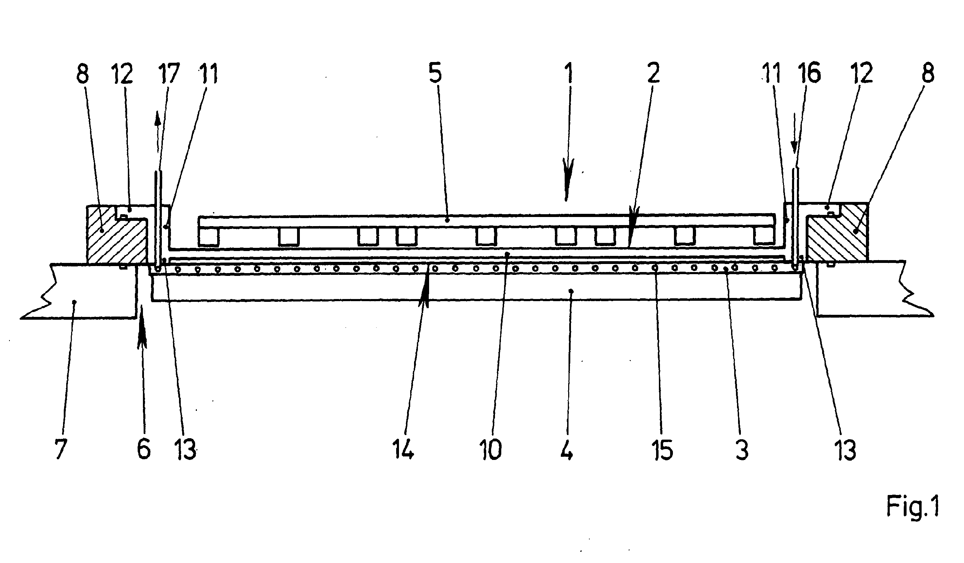

- Fig.1: eine Prinzipdarstellung einer erfindungsge- mäßen Magnetron-Sputter-Kathode im Schnitt und
- Fig.2: eine perspektivische Darstellung einer aus mehreren Segmenten zusammengesetzten Rücken- platte.

Die Sputter-Kathode 1 besteht aus einem Träger 2, an dessen Vakuumseite zunächst eine als Kühlplatte ausgestaltete Rückenplatte 3 für ein Sputter-Target 4 vorgesehen ist. An der Atmosphärenseite befindet sich eine Magnetanordnung 5, die durch ein nicht näher dargestelltes Verschiebesystem parallel zum Sputter-Target 4 hin und her bewegt werden kann.

Die Rückenplatte 3 wird in eine Öffnung 6 in der Gehäusewand 7 eines Vakuumbehälters dichtend eingesetzt. Dazu ist ein Isolator 8 vorgesehen, der einerseits den Träger 2 gegenüber der Gehäusewand 7 elektrisch isoliert und gleichzeitig sicherstellt, dass die Verbindung luftdicht ist.

Der Träger 2 besteht aus einer Platte 10 mit einer umlaufenden Verstärkungsrippe 11, die einen nach außen abgesetzten Flansch 12 aufweist. Zwischen diesem Flansch 12 und der Gehäusewand 7 befindet sich der Isolator 8, der an der Außenseite der Verstärkungsrippe 11 anliegt. Zur Vakuumseite hin sind die Verstärkungsrippen 11 in Stege 13 verlängert, auf denen die Rückenplatte 3 aufliegt, so dass sich zwischen der Platte 10 des Trägers 2 und der Rückenplatte 3 ein Spalt 14 bildet. Bei einer evakuierten Kammer ist auch dieser Spalt evakuiert, so dass die Rückenplatte 3 und damit das Sputter-Target 4 druckfrei sind.

In der Rückenplatte 3 befinden sich Kühlkanäle 15, die über einen Zulauf 16 mit Kühlflüssigkeit versorgt werden, das über einen Rücklauf 17 zurückgeführt wird. Der Zulauf 16 und der Rücklauf 17 werden durch die Verstärkungsrippen 11 und den Steg 13 geführt.

Wie schon erwähnt, hat eine solche Anordnung den Vorteil, dass der Träger 2 dahingehend ausgelegt werden kann, dass er in der Lage ist, den bei einer evakuierten Kammer herrschenden Atmosphärendruck zu halten, während das Sputter-Target 4 und die Rückenplatte 3 selbst keinem Differenzdruck ausgesetzt sind.

Der Spalt 14 ermöglicht sogar eine leichte Durchbiegung des Trägers 2, ohne dass sich dies auf das Sputter-Target 4 auswirkt.

Die Stabilität des Trägers 2 wird insbesondere durch die Versteifungsrippe 11 erzeugt, so dass seine Platte 10 selbst nicht sehr dick ausgeführt zu sein braucht, so dass die Magnete der Magnetanordnung 5 relativ nahe dem Sputter-Target 4 angeordnet werden können.

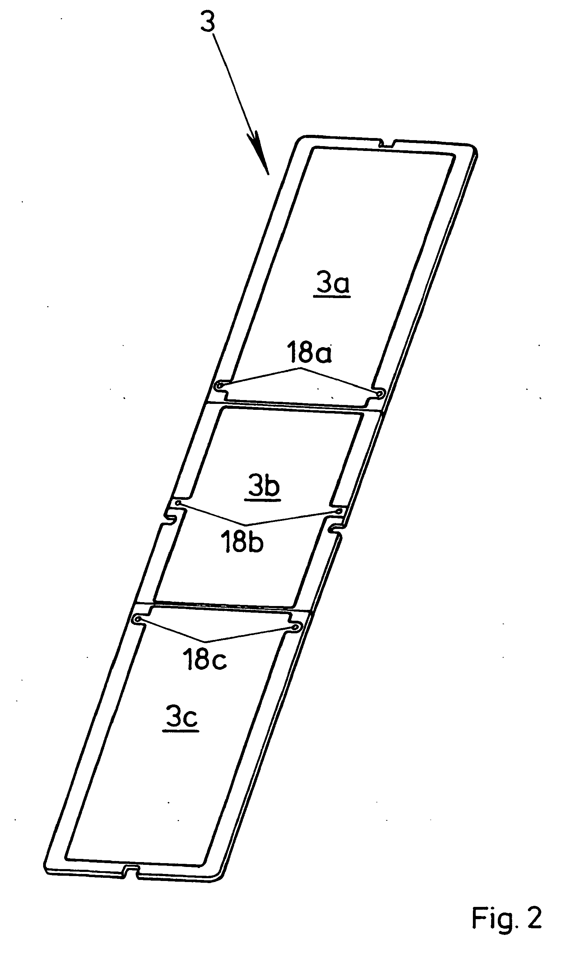

Wie die Figur 2 zeigt, kann die Rückenplatte 3 aus mehreren Segmenten 3a, 3b, 3c zusammengesetzt sein. Dies empfiehlt sich insbesondere, wenn das Target als Ganzes eine relativ große Längsausdehnung haben soll. Der Träger 2 besteht weiterhin aus einer durchgehenden Platte 10 mit in Längsrichtung verlaufenden Versteifungsrippen 11 und Stegen 13. Die einzelnen Segmente 3a, 3b, 3c der Rückenplatte 3 sind in Längsrichtung des Trägers 2 betrachtet nebeneinander gesetzt und überspannen ihn jeweils von einem zum gegenüberliegenden Steg 13. Jedes Segment 3a, 3b, 3c ist einzeln am Träger 2 befestigt und weist einen eigenen Kühlwasserkreislauf mit einem eigenen Anschluss 18a, 18b, 18c zum Zu- bzw. Ablauf 16, 17 am Träger 2 auf.

### Bezugszeichenliste

- 1: Magnetron-Sputter-Kathode
- 2: Träger
- 3: Rückenplatte (a, b, c: Segmente)
- 4: Sputter-Target
- 5: Magnetanordnung

- 6: Öffnung
- 7: Gehäuse
- 8: Isolator
- *:
- 10: Trägerplatte

- 11: Versteifungsrippe
- 12: Flansch
- 13: Steg
- 14: Spalt
- 15: Kanäle

- 16: Zulauf
- 17: Rücklauf
- 18: Anschluss

## Patentansprüche

1. Magnetron-Sputter-Kathode mit einem Verschlusselement, das in eine Öffnung (6) der Gehäusewand einer Vakuumkammer einsetzbar ist, wodurch die Öffnung (6) luftdicht verschlossen und das Verschlusselement elektrisch von der Gehäusewand isoliert ist, mit einem Sputter-Target (4) an der Vakuumseite des Verschlusselementes, mit einer parallel zum Sputter-Target (4) hin und her bewegbaren Magnetanordnung (5) an dessen Atmosphärenseite und mit einer mit einer Kühlflüssigkeit betriebenen Kühlplatte für das Sputter-Target (4), wobei die mit Kühlkanälen (15) versehene Kühlplatte an der Vakuumseite zwischen dem als einem Träger (2) ausgeführten Verschlusselement und dem Sputter-Target (4) angeordnet ist und die Rückenplatte (3) des Sputter-Targets (4) bildet, wobei der Träger (2) Durchleitungen für die Kühlflüssigkeit aufweist und die Kühlkanäle (15) innerhalb der Kühlplatte einen geschlossenen Querschnitt aufweisen, so dass eine durchgehende Kontaktfläche zum Sputter-Target (4) besteht, und wobei zwischen der Rückenplatte (3) und dem Träger (2) Abstandshalter vorgesehen sind, so dass zwischen dem zentralen Bereich der Rückenplatte (3) und dem Träger (2) ein Spalt (14) verbleibt, wobei bei einer evakuierten Vakuumkammer auch der Spalt evakuiert ist, **dadurch gekennzeichnet, dass** die Abstandshalter von Stegen (13) gebildet sind, an denen der Rand der Rückenplatte (3) mit ihrer von dem Sputter-Target (4) abgewandten Seite derart anliegend befestigt ist,
dass der Spalt eine Durchbiegung des Trägers (2) erlaubt, weil die Rückenplatte (3) und damit das Sputter-Target (4) druckfrei sind.

2. Magnetron-Sputter-Kathode nach Anspruch 1, **dadurch gekennzeichnet, dass** die Stege (13) einstückig mit dem Träger (2) and zur Durchleitung der Kühlflüssigkeit durch die Stege (13) ausgebildet sind.

3. Magnetron-Sputter-Kathode nach Anspruch 1, **dadurch gekennzeichnet, dass** der Träger (2) an der Atmosphärenseite zwei randständige Versteifungsrippen (11) aufweist.

4. Magnetron-Sputter-Kathode nach Anspruch 3, **dadurch gekennzeichnet, dass** wenigstens zwei längliche Sputter-Targets (4) mit je einer Rückenplatte (3) nebeneinander auf dem Träger (2) angeordnet sind, und dass jedem Sputter-Target (4) eine einen Race-track erzeugende Magnetanordnung (5) zugeordnet ist.

5. Magnetron-Sputter-Kathode nach einem der vorhergehenden Ansprüche, **dadurch gekennzeichnet, dass** jedes Sputter-Target (4) aus mehreren aneinanderstoßenden Sputter-Target-Segmenten zusammengesetzt ist.

6. Magnetron-Sputter-Kathode nach Anspruch 5, **dadurch gekennzeichnet, dass** jedem Sputter-Target-Segment eine Einzelrückenplatte zugeordnet ist, die eine eigene Kühlwasserversorgung aufweist.

## Claims

1. Magnetron sputter cathode with a closure element, which can be set into an opening (6) of the housing wall of a vacuum chamber, whereby the opening (6) is closed airtight and the closure element is electrically insulated against the housing wall, with a sputter target (4) at the vacuum side of the closure element, with a magnet configuration (5), which can be moved back and forth parallel to the sputter target (4), at its atmospheric side, and with a cooling plate operated with a cooling fluid for the sputter target (4), the cooling plate provided with cooling channels (15) being disposed on the vacuum side between the closure element implemented as a carrier (2) and the sputter target (4) and forming the backing plate (3) of the sputter target (4), the carrier (2) comprising through-conduits for the cooling fluid and the cooling channels (15) within the cooling plate having a closed cross section, such that there is a continuous contact face to the sputter target (4), and wherein between the backing plate (3) and the carrier (2) spacers are provided, such that between the central region of the backing plate (3) and the carrier (2) a gap (14) remains, whereby with the vacuum chamber evacuated, the gap is also evacuated, **characterized in that** the spacers are formed by webs (13), on which the margin of the backing plate (3), with its side facing away from the sputter target (4) is fastened in contact, such that the gap permits a deflection of the carrier (2) since the backing plate (3), and therewith the sputter target (4), are free of pressure.

2. Magnetron sputter cathode as claimed in claim 1, **characterized in that** the webs (13) are formed integrally with the carrier (2) and for conducting the cooling fluid through the webs (13).

3. Magnetron sputter cathode as claimed in claim 1, **characterized in that** the carrier (2) has two marginal reinforcement ribs (11) at the atmospheric side.

4. Magnetron sputter cathode as claimed in claim 3, **characterized in that** at least two elongated sputter targets (4) each with one backing plate (3) are disposed adjacent to one another on the carrier (2), and that to each sputter target (4) a magnet configuration (5) generating a race track is assigned.

5. Magnetron sputter cathode as claimed in one of the preceding claims, **characterized in that** each sputter target (4) is composed of several sputter target segments abutting one another.

6. Magnetron sputter cathode as claimed in claim 5, **characterized in that** to each sputter target segment one individual backing plate is assigned, which has its own cooling water supply.

## Revendications

1. Cathode de pulvérisation magnétron avec un élément obturateur qui peut être inséré dans une ouverture (6) de la paroi de carter d'une chambre à vide, fermant ainsi l'ouverture (6) de manière hermétique et isolant électriquement l'élément obturateur par rapport à la paroi de carter, avec une cible de pulvérisation (4) située côté vide de l'élément obturateur, avec, du côté atmosphère de celui-ci, une disposition d'aimants (5) pouvant être déplacée, dans un mouvement de va-et-vient, parallèlement à la cible de pulvérisation (4), et avec une plaque de refroidissement, alimentée par un liquide de refroidissement, pour la cible de pulvérisation (4), la plaque de refroidissement pourvue de canaux de refroidissement (15) étant disposée, côté vide, entre l'élément obturateur réalisé sous la forme d'un support (2) et la cible de pulvérisation (4), et formant la plaque arrière (3) de la cible de pulvérisation (4), le support (2) présentant des conduites traversantes pour le liquide de refroidissement et les canaux de refroidissement (15) présentant, à l'intérieur de la plaque de refroidissement, une section fermée, de sorte qu'il existe une surface de contact continue avec la cible de pulvérisation (4), et des écarteurs étant prévus entre la plaque arrière (3) et le support (2), de sorte qu'une fente (14) subsiste entre la zone centrale de la plaque arrière (3) et le support (2), ladite fente étant elle aussi sous vide lorsque la chambre à vide se trouve sous vide, **caractérisée en ce que** les écarteurs sont formés par des barrettes (13) auxquelles est fixé le bord de la plaque arrière (3) avec son côté opposé à la cible de pulvérisation (4), et ce avec une justesse telle que la fente permet au support (2) de fléchir parce que la plaque arrière (3), et donc la cible de pulvérisation (4), sont exemptes de pression.

2. Cathode de pulvérisation magnétron selon la revendication 1, **caractérisée en ce que** les barrettes (13) sont réalisées en une seule pièce avec le support (2) et de manière à permettre le passage du fluide de refroidissement à travers lesdites barrettes (13).

3. Cathode de pulvérisation magnétron selon la revendication 1, **caractérisée en ce que** le support (2) présente, du côté atmosphère, deux nervures raidisseuses (11) situées au bord.

4. Cathode de pulvérisation magnétron selon la revendication 3, **caractérisée en ce qu'**au moins deux cibles de pulvérisation (4) de forme allongée pourvues chacune d'une plaque arrière (3) sont disposées côte à côte sur le support (2), et **en ce qu'**a chaque cible de pulvérisation (4) est affectée une disposition d'aimants (5) générant une trajectoire donnée ("race track").

5. Cathode de pulvérisation magnétron selon l'une des revendications précédentes, **caractérisée en ce que** chaque cible de pulvérisation (4) se compose de plusieurs segments de cible de pulvérisation mis bout à bout.

6. Cathode de pulvérisation magnétron selon la revendication 5, **caractérisée en ce qu'**à chaque segment de cible de pulvérisation est affectée une plaque arrière individuelle qui présente une alimentation en eau de refroidissement qui lui est propre.
